# EUROPEAN PATENT APPLICATION

(11) **EP 4 625 141 A1**
(43) Date of publication of application: **01.10.2025**
(21) Application number: 24202527.8
(22) Date of filing: 25.09.2024
(51) Int. Cl.: G06F 7/58

(54) **RANDOM NUMBER GENERATOR**

(30) Priority: 29.03.2024 KR 20240043501
(71) Applicant: Samsung Electronics Co., Ltd, Suwon-si, Gyeonggi-do 16677 (KR)
(72) Inventor: CHOI, Yunhyeok, Suwon-si (KR); LEE, Young Ki, Suwon-si (KR); PARK, Jieun, Suwon-si (KR); KARPINSKYY, Bohdan, Suwon-si (KR)
(74) Representative: Marks & Clerk LLP

(57) **Abstract**

A random number generator, including: an oscillator configured to generate a first oscillation signal; a signal generator configured to generate a first clock signal based on the first oscillation signal and a pause signal, and to generate a second clock signal based on the pause signal; a duty rectifier configured to generate a second oscillation signal based on the first clock signal, wherein a pulse width of the second oscillation signal is greater than a pulse width of the first clock signal; and a sampler configured to sample the second oscillation signal based on the second clock signal.

## Description

### BACKGROUND

### 1. Field

The disclosure relates to a random number generator.

### 2. Description of Related Art

In general, random numbers may be used to generate secret keys for security systems. Accordingly, a security system may be equipped with a random number generator. These random number generators may generate random numbers with unpredictable values. It may be desirable for security systems to generate completely random numbers that are unpredictable and have no periodicity. True random numbers may be generated from a physical noise source, may be unpredictable, and may have no periodicity. Some true random number generators may generate random numbers using thermal noise, shot noise, or a clock signal with an irregular period of a ring oscillator.

### SUMMARY

Provided is a random number generator capable of generating random numbers without bias.

Additional aspects will be set forth in part in the description which follows and, in part, will be apparent from the description, or may be learned by practice of the presented embodiments.

In accordance with an aspect of the disclosure, a random number generator includes: an oscillator configured to generate a first oscillation signal; a signal generator configured to generate a first clock signal based on the first oscillation signal and a pause signal, and to generate a second clock signal based on the pause signal; a duty rectifier configured to generate a second oscillation signal based on the first clock signal, wherein a pulse width of the second oscillation signal is greater than a pulse width of the first clock signal; and a sampler configured to sample the second oscillation signal based on the second clock signal.

In accordance with an aspect of the disclosure, a random number generator includes: an oscillator configured to generate a first oscillation signal; a synchronizer configured to generate a synchronization signal based on a pause signal and the first oscillation signal; a duty rectifier configured to generate a second oscillation signal based on the first oscillation signal, wherein a pulse width of the second oscillation signal is greater than a pulse width of the first oscillation signal; and a sampler configured to sample the second oscillation signal based on the synchronization signal.

In accordance with an aspect of the disclosure, a random number generator includes: a first oscillator configured to generate first oscillation signal having a first pulse width; a first inverter configured to generate a first inversion signal by inverting the first oscillation signal; a second oscillator configured to generate a second oscillation signal having a second pulse width; a first synchronizer configured to generate a first synchronization signal based on a pause signal and the second oscillation signal; a second inverter configured to generate a second inversion signal by inverting the first synchronization signal; a second synchronizer configured to generate a second synchronization signal based on the first inversion signal and the second inversion signal; a duty rectifier configured to generate the second oscillation signal based on the first oscillation signal, wherein the second oscillation signal has a greater pulse width than the first oscillation signal; and a sampler configured to sample the second oscillation signal based on the second synchronization signal.

At least some of the above and other features of the disclosure are set out in the claims.

### BRIEF DESCRIPTION OF DRAWINGS

The above and other aspects, features, and advantages of certain embodiments of the present disclosure will be more apparent from the following description taken in conjunction with the accompanying drawings, in which:
FIG. 1 is a schematic block diagram of a semiconductor device according to an embodiment;
FIG. 2 is a block diagram of a true random number generator (TRNG) according to an embodiment;
FIG. 3 is a circuit diagram of a ring oscillator according to an embodiment;
FIG. 4 is a circuit diagram of a signal generator according to an embodiment;
FIG. 5 is a timing diagram for explaining an operation of a TRNG according to an embodiment;
FIG. 6 is a block diagram of a TRNG according to an embodiment;
FIG. 7 is a circuit diagram of a signal generator according to an embodiment;
FIG. 8 is a timing diagram for explaining an operation of a TRNG according to an embodiment;
FIG. 9 is a block diagram of a TRNG according to an embodiment;
FIG. 10 is a circuit diagram of a signal generator according to an embodiment;
FIG. 11 is a timing diagram for explaining an operation of a TRNG according to an embodiment;
FIG. 12 is a block diagram of a TRNG according to an embodiment;
FIG. 13 is a timing diagram for explaining an operation of a TRNG according to an embodiment;
FIG. 14 is a block diagram of a TRNG according to an embodiment;
FIG. 15 is a timing diagram for explaining an operation of a TRNG according to an embodiment;
FIG. 16 is a block diagram of a TRNG according to an embodiment;
FIG. 17 is a timing diagram for explaining an operation of a TRNG according to an embodiment;
FIG. 18 is a block diagram of a TRNG according to an embodiment; and
FIG. 19 is a block diagram of a computing system according to an embodiment.

### DETAILED DESCRIPTION

In the following detailed description, only some embodiments of the present disclosure have been shown and described, simply by way of illustration. As those skilled in the art would realize, the described embodiments may be modified in various different ways, all without departing from the scope of the present disclosure.

Accordingly, the drawings and description are to be regarded as illustrative in nature and not restrictive or limiting. Like reference numerals designate like elements throughout the disclosure. In a flowchart described with reference to the drawings, an order of operations may be changed, several operations may be merged, some operations may be divided, and particular operations may not be performed.

In addition, expressions written in the singular may be construed in the singular or plural unless an explicit expression such as "one" or "single" is used. Terms including ordinal numbers such as first, second, and the like are used only to describe various components, and are not to be interpreted as limiting these components. These terms may be used for the purpose of distinguishing one element from other elements, without limiting the elements to any particular order.

As is traditional in the field, embodiments may be described and illustrated in terms of blocks which carry out a described function or functions. These blocks, which may be referred to herein as units or modules or the like, are physically implemented by analog or digital circuits such as logic gates, integrated circuits, microprocessors, microcontrollers, memory circuits, passive electronic components, active electronic components, optical components, hardwired circuits, or the like, and may optionally be driven by firmware and software. The circuits may, for example, be embodied in one or more semiconductor chips, or on substrate supports such as printed circuit boards and the like. The circuits included in a block may be implemented by dedicated hardware, or by a processor (e.g., one or more programmed microprocessors and associated circuitry), or by a combination of dedicated hardware to perform some functions of the block and a processor to perform other functions of the block. Each block of the embodiments may be physically separated into two or more interacting and discrete blocks without departing from the scope of the disclosure. Likewise, the blocks of the embodiments may be physically combined into more complex blocks without departing from the scope of the disclosure. For example, used herein, the expression "control logic" may refer to a control logic circuit, but embodiments are not limited thereto.

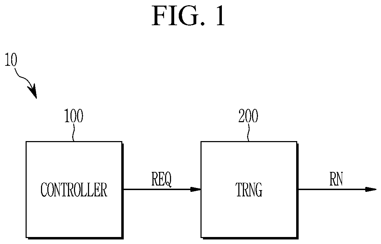

FIG. 1 is a schematic block diagram of a semiconductor device according to an embodiment.

Referring to FIG. 1, a semiconductor device 10 according to an embodiment may be disposed or otherwise included in an electronic device. For example, the electronic device may be one or more of a personal computer (PC), a laptop computer, a mobile phone, a smart phone, a tablet PC, a personal digital assistant (PDA), an enterprise digital assistant (EDA), a digital still camera, a digital video camera, a portable multimedia player (PMP), a personal navigation device or portable navigation device (PND), a handheld game console, a mobile Internet device (MID), a wearable computer, an Internet of Things (IoT) device, an Internet of Everything (IoE) device, and a drone.

The semiconductor device 10 may include a controller 100 and a true random number generator (TRNG) 200. The controller 100 may be implemented as at least one of various processing units such as a central processing unit (CPU), a graphics processing unit (GPU), or an application processor (AP), or the like.

In an embodiment, the semiconductor device 10 may be implemented as a semiconductor chip. The semiconductor chip may further include a memory device, a phase-locked loop (PLL) circuit, and the like. However, embodiments are not limited thereto, but a controller 100 and the TRNG 200 may also be implemented as individual semiconductor chips.

The controller 100 may transmit a request signal REQ to the TRNG 200. The request signal REQ may be a signal requesting random number generation. The TRNG 200 may generate a random number RN in response to the request signal REQ of the controller 100. In some embodiments, the TRNG 200 may transfer the random number RN to the controller 100 or to other components. According to embodiments, the expression "in response to" may mean, for example, "based on", but embodiments are not limited thereto.

The TRNG 200 may be a jitter-based random number generator. The TRNG 200 may accumulate jitters for a predetermined time, and based on the accumulated jitter, a phase change of an oscillation signal may be large. The TRNG 200 may generate the random number RN based on the phase change. For the purposes of the subject disclosure, jitter is understood to refer to deviation of a presumably periodic signal from true periodicity.

The TRNG 200 may include a ring oscillator which may output the oscillation signal in response to the request signal REQ. For example, the request signal REQ may operate as an enable signal of the ring oscillator. According to embodiments, signals such as the request signal REQ may be output at one or more voltage levels, for example a high level, which may be a voltage level corresponding to a logic high value such as a value of one ("1"), and a low level, which may be a voltage level corresponding to a logic low value such as a value of zero ("0"). The request signal REQ may maintain the high level until the TRNG 200 generates the random number RN. The TRNG 200 may output a random bit based on the oscillation signal of the ring oscillator. For example, the TRNG 200 may output a random bit using the predetermined sampling interval, and the TRNG 200 may accumulate random bits outputted during the predetermined time and output it as the random number RN.

The TRNG 200 may hold the oscillation signal of the ring oscillator before performing the sampling. The TRNG 200 may stably generate random bits by holding the oscillation signal before the sampling. Holding of the oscillation signal may be understood as outputting a signal that does not oscillate. For example, the TRNG 200 may include an AND gate, and may hold the oscillation signal by inputting the oscillation signal to one input end of the AND gate and inputting a value of zero ("0") to another input end. The signal output by the AND gate may not oscillate in response to the value of zero ("0").

In an embodiment, the TRNG 200 may asynchronously perform a hold operation on the oscillation signal. For example, the TRNG 200 may perform the hold operation before the sampling time point regardless of edges of the oscillation signal.

In an embodiment, the TRNG 200 may synchronously perform the hold operation on the oscillation signal. The TRNG 200 may perform the hold operation at the edge of the oscillation signal. For example, the TRNG 200 may perform the hold operation at a falling edge of the oscillation signal, and may output a random bit based on the rising edge of the oscillation signal.

In some embodiments, the TRNG 200 may also include a plurality of ring oscillators. For example, the TRNG 200 may include a first ring oscillator corresponding to a first frequency and a second ring oscillator corresponding to a second frequency. Because all of the jitter component of the first ring oscillator and the jitter component of the second ring oscillator may affect generation of random bits, the TRNG 200 may generated unbiased random bits, and may stably generate the random number RN. In some embodiments, the TRNG 200 may further include a ring oscillator corresponding to a different frequency.

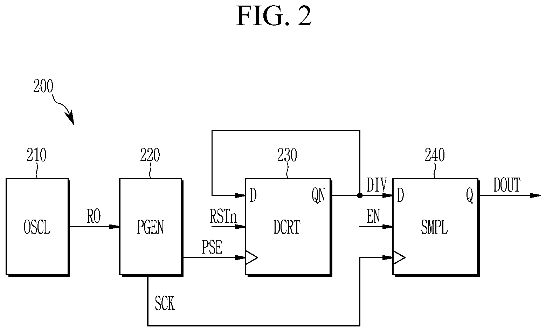

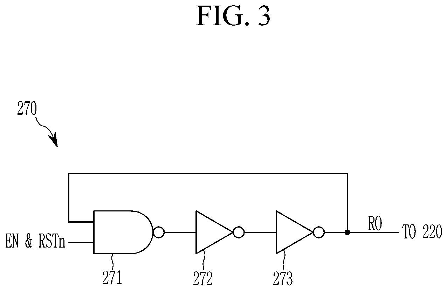

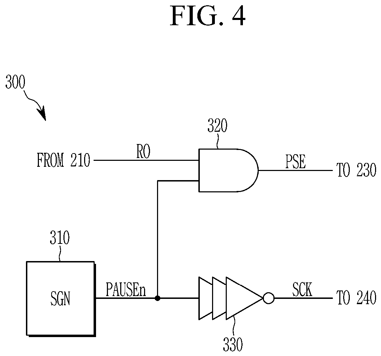

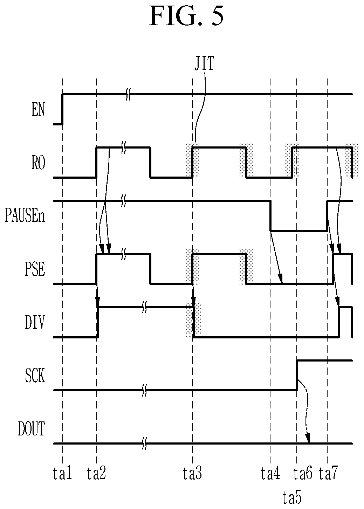

FIG. 2 is a block diagram of a TRNG according to an embodiment. FIG. 3 is a circuit diagram of the ring oscillator according to an embodiment. FIG. 4 is a circuit diagram of a signal generator according to an embodiment. FIG. 5 is a timing diagram for explaining an operation of a TRNG according to an embodiment.

Referring to FIG. 2, the TRNG 200 according to an embodiment may generate a signal DOUT by asynchronously performing pause operations (which may be referred to as hold operations). The TRNG 200 may include an oscillator 210 (illustrated as "OSCL"), a signal generator 220 (illustrated as "PGEN"), a duty rectifier 230 (illustrated as "DCRT"), and a sampler 240 (illustrated as "SMPL").

The oscillator 210 may generate the oscillation signal RO. The oscillator 210 may be the ring oscillator. The TRNG 200 may generate the signal DOUT based on the oscillation signal RO. The oscillator 210 may transfer the oscillation signal RO to the signal generator 220.

Referring to FIG. 3, an oscillator 270 according to an embodiment may include a NAND gate 271, an inverter 272, and an inverter 273. The NAND gate 271 may receive a first signal as a first input, and may receive a second signal as a second input. The NAND gate 271 may perform a Not AND (NAND) operation on the first signal and the second signal. The NAND gate 271 may transfer the operation result to the inverter 272.

In an embodiment, the oscillation signal RO may be input to the NAND gate 271 as the first signal. A logical product operation result EN&RSTn of an enable signal EN and an initialization signal RSTn may be input to the NAND gate 271 as the second signal. The enable signal EN may comprise a request signal, i.e., a signal requesting random number generation. For example, the oscillator 270 may further include an AND gate receiving the enable signal EN and the initialization signal RSTn and perform a logical product operation. The AND gate may transfer the operation result to the NAND gate 271.

The initialization signal RSTn may be a signal for initializing the oscillator 270, and may be generated by the control logic of the TRNG 200. When the TRNG 200 outputs the signal DOUT, the control logic may generate the initialization signal RSTn having a first level, and the oscillator 270 may be initialized. For example, the first level may be the low level, and a second level may be the high level. The control logic may also input the initialization signal RSTn to the duty rectifier 230. In some embodiments, an external control logic (e.g., the controller 100 of FIG. 1), which may be separate from the TRNG 200, may also generate the initialization signal RSTn.

The inverters 272 and 273 may be configured to invert the input signal. The inverters 272 and 273 may generate the oscillation signal RO by inverting the operation result of the NAND gate 271. An inverter 273 may transfer the oscillation signal RO to the signal generator 220 and the NAND gate 271.

FIG. 3 illustrates an example in which the oscillator 270 includes two inverters 272 and 273, but embodiments are not limited thereto, and in some embodiments the oscillator 270 may also be implemented to include a different number of inverters. The frequency of the oscillation signal RO may be determined according to the number of the inverters 272 and 273 included in the oscillator 270. For example, oscillators having different frequencies may have different numbers of inverters.

The signal generator 220 may receive the oscillation signal RO. The signal generator 220 may generate a signal PSE based on the oscillation signal RO. The signal PSE may be a signal in which the oscillation signal RO does not oscillate during a particular time period. For example, the signal generator 220 may include an AND gate. The signal generator 220 may input the oscillation signal RO to one input of the AND gate, and input a value of zero ("0") to another input, such that the generated signal PSE may oscillate before a particular time point and then may not oscillate after the particular time point. The signal generator 220 may transfer the signal PSE to the duty rectifier 230.

In addition, the signal generator 220 may generate a clock signal SCK. The clock signal SCK may be used for sampling of the sampler 240. The TRNG 200 may stably generate random numbers only if the jitters are accumulated for a sufficient time. Accordingly, a signal generator 220 may generate the clock signal SCK having a period greater than the sufficient time. The signal generator 220 may transfer the clock signal SCK to the sampler 240.

Referring to FIG. 4, a signal generator 300 according to an embodiment may include a control logic 310 (illustrated as "SGN"), an AND gate 320, and a delay inversion circuit 330. The control logic 310 may generate a pause signal PAUSEn. The pause signal PAUSEn may be a signal for holding the oscillation signal RO. The pause signal PAUSEn may hold the oscillation of the oscillation signal RO before the sampler 240 performs the sampling. In some embodiments, the frequency of the pause signal PAUSEn may be the same as the frequency of the initialization signal RSTn of FIG. 2.

For example, the control logic 310 may generate the pause signal PAUSEn having a second level while the jitter is accumulated in the oscillation signal RO, and may generate the pause signal PAUSEn having the first level after the jitter is sufficiently accumulated and before the signal DOUT is generated. When a predetermined time has elapsed from a rising edge of the enable signal EN, the control logic 310 may periodically generate the pause signal PAUSEn having the first level. The signal PSE having the first level may be output in response to the pause signal PAUSEn having the first level. Accordingly, a signal DIV of the duty rectifier 230 may be held such that the sampler 240 may stably generate the signal DOUT. The control logic 310 may transfer the pause signal PAUSEn to the AND gate 320 and the delay inversion circuit 330.

The AND gate 320 may perform a logical product operation on the oscillation signal RO and the pause signal PAUSEn to generate the signal PSE. For example, the AND gate 320 may output the oscillation signal RO as the signal PSE in response to the pause signal PAUSEn having the second level. The AND gate 320 may transfer the signal PSE to the duty rectifier 230. The signal PSE may operate as clock signal of the duty rectifier 230. The AND gate 320 may output a signal having the first level in response to the pause signal PAUSEn having the first level. The duty rectifier 230 may receive a signal that does not oscillate.

The delay inversion circuit 330 may generate the clock signal SCK based on the pause signal PAUSEn. For example, the delay inversion circuit 330 may generate the clock signal SCK by delaying and inverting the pause signal PAUSEn. However, this is only an example, and the sequence of performing delay and inversion is not limited thereto. The delay inversion circuit 330 may transfer the clock signal SCK to the sampler 240.

In an embodiment, the delay inversion circuit 330 may include an odd number of inverters. An even number of inverters may be included in the odd number of inverters. The even number of inverters may operate as a delay circuit. However, embodiments are not limited thereto, but the delay inversion circuit 330 may also be implemented as a logic circuit for delaying and inverting the pause signal PAUSEn. In some embodiments, the number of inverters included in the delay inversion circuit 330 may be implemented to be different.

Referring again to FIG. 2, the duty rectifier 230 may be implemented as a flip-flop. The duty rectifier 230 may operate based on the signal PSE. The duty rectifier 230 may generate the signal DIV having a uniform duty based on the signal PSE. For example, even if the oscillation signal RO of the oscillator 210 is not uniform, the duty rectifier 230 may generate the signal DIV having a uniform duty. For example, the oscillator 210 may generate an oscillation signal RO in which the slopes of a rising edge and a falling edge are different. Accordingly, the ratio of the first level and the second level of the oscillation signal RO may not be 1:1. The duty rectifier 230 may generate the signal DIV such that the ratio of the first level and the second level is 1:1.

The duty rectifier 230 may be a counter. The duty rectifier 230 may count the number of times that the signal PSE transitions from the first level to the second level. For example, as discussed above, the first level may be a low level, and the second level may be a high level. The duty rectifier 230 may generate the signal DIV based on the signal PSE. The duty rectifier 230 may generate the signal DIV such that the state transitions in response to a rising edge of the signal PSE (e.g., based on a transition of the signal PSE from the first level to the second level). The duty rectifier 230 may output the signal DIV through the QN pin. The duty rectifier 230 may transfer the signal DIV to the sampler 240. In addition, the duty rectifier 230 may input the signal DIV to a D pin of the duty rectifier 230.

In an embodiment, the duty rectifier 230 may count whether the rising edge of the signal PSE has occurred an odd number of times or an even number of times. For example, the duty rectifier 230 may be a counter for counting a least significant bit (LSB). When the rising edge has occurred an odd number of times, the duty rectifier 230 may generate a rising edge and output a value of one ("1") as the signal DIV. When the rising edge has occurred by an even number of times, the duty rectifier 230 may generate a falling edge and output a value of zero ("0") as the signal DIV. In another embodiment, the duty rectifier 230 may also be implemented to count the falling edge of the signal PSE.

The duty rectifier 230 may be initialized based on the initialization signal RSTn. The initialization signal RSTn may be generated by the control logic of the TRNG 200. When the sampler 240 outputs the signal DOUT, the control logic may input the initialization signal RSTn to the duty rectifier 230. In some embodiments, the period of the initialization signal RSTn and the period of the clock signal SCK may be substantially the same. For example, the period in which the initialization signal RSTn transitions from the second level to the first level and the period in which the clock signal SCK transitions from the first level to the second level may be substantially the same.

The sampler 240 may be implemented as a flip-flop. In some embodiments, the sampler 240 may include substantially the same structure as the duty rectifier 230. The sampler 240 may initiate a sampling operation in response to the enable signal EN. For example, when the enable signal EN transitions from the first level to the second level, the sampler 240 may initiate operation. The sampler 240 may sample the signal DIV using the clock signal SCK. The sampler 240 may sample the signal DIV when the clock signal SCK transitions from the first level to the second level. The sampler 240 may perform the sampling and output the sampling result as the signal DOUT.

Due to the pause signal PAUSEn, the signal PSE may maintain the first level, and because the signal DIV may maintain the value corresponding to a time point at which the pause signal PAUSEn is input, the signal DIV may not transition when the sampler 240 performs the sampling. For example, this may allow the sampler 240 may stably perform sampling.

Referring to FIG. 2 to FIG. 5, at a time point ta1, the enable signal EN may change from the low level to the high level. In response to the enable signal EN having the high level, the oscillator 210 and the sampler 240 may initiate operation. In some embodiments, the duty rectifier 230 may also be implemented to initiate operation in response to the enable signal EN, instead of being initialized based on the enable signal EN.

At a time point ta2, the oscillator 210 may transition the oscillation signal RO from the low level to the high level. Because the pause signal PAUSEn is at the high level, the signal PSE may be substantially the same as the oscillation signal RO. In response to the transition of the signal PSE from the low level to the high level at the time point ta2, the duty rectifier 230 may generate the signal DIV having the high level.

When a time point ta3 is reached after the predetermined time, a jitter JIT may be sufficiently accumulated in the oscillation signal RO of the oscillator 210. The accumulated jitter JIT may also affect the signal PSE and the signal DIV, enabling the sampler 240 to stably output random bits. In response to the transition of the signal PSE from the low level to the high level at the time point ta3, the duty rectifier 230 may generate the signal DIV having the low level.

At a time point ta4, the control logic 310 may generate the pause signal PAUSEn having the low level. The AND gate 320 may generate the signal PSE having the low level based on the pause signal PAUSEn of low level. The duty rectifier 230 may maintain the signal DIV having the low level based on the signal PSE having the low level.

At a time point ta5, even if the oscillation signal RO transitions from the low level to the high level, due to the pause signal PAUSEn having the low level, the signal PSE may not oscillate.

At a time point ta6, the clock signal SCK may transition to the high level. The clock signal SCK may be a signal obtained as the pause signal PAUSEn is delayed and inverted. For example, the delay inversion circuit 330 may generate the clock signal SCK by delaying and inverting the pause signal PAUSEn. The sampler 240 may sample the signal DIV in response to a rising edge of the clock signal SCK. Because the signal DIV is stationary, it may be ignored even if the duty rectifier 230 might have a duty problem or previous value dependency. In addition, the sampler 240 may need a setup time and a hold time for the sampling, and because the signal DIV is stationary, the time constraint of the sampler 240 may also be ensured. For example, the sampler 240 may stably perform sampling, and as a sampling result, output the signal DOUT having the low level.

When the pause signal PAUSEn reaches the high level at a time point ta7, based on the oscillation signal RO having the high level, the signal PSE may also become the high level, and the level transition may also occur in the signal DIV.

After the sampler 240 performs the sampling, the initialization signal RSTn may transition to the low level. In response to the initialization signal RSTn having the low level, the oscillator 210 and the duty rectifier 230 may be initialized.

In some embodiments, the oscillator 210, the duty rectifier 230, and the sampler 240 may also be implemented to operate based on the same enable signal EN and initialization signal RSTn. For example, the oscillator 210, the duty rectifier 230, and the sampler 240 may be turned on or activated based on the enable signal EN, and may be initialized based on the initialization signal RSTn.

In some embodiments, the oscillator 210, the duty rectifier 230, and the sampler 240 may operate based on the enable signal EN, and the level of the enable signal EN may transition at the same period as the sampling period. For example, the oscillator 210, the duty rectifier 230, and the sampler 240 may be periodically initialized.

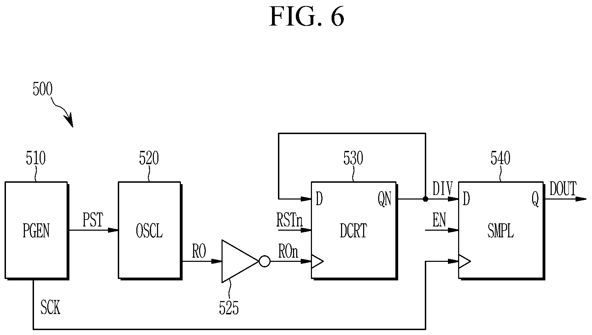

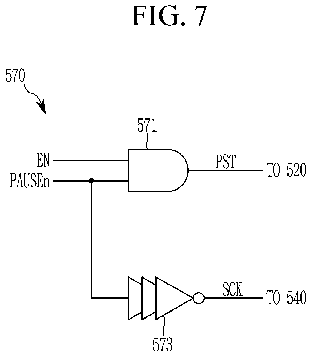

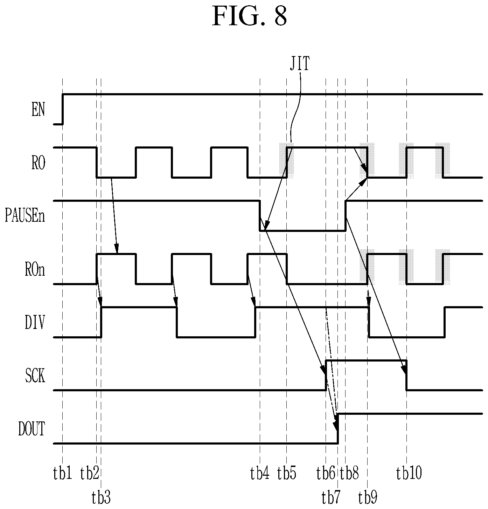

FIG. 6 is a block diagram of a TRNG according to an embodiment. FIG. 7 is a circuit diagram of a signal generator according to an embodiment. FIG. 8 is a timing diagram for explaining an operation of a TRNG according to an embodiment.

Referring to FIG. 6, a TRNG 500 according to an embodiment may generate the signal DOUT by asynchronously performing the pause operation. The TRNG 500 may include a signal generator 510 (illustrated as "PGEN"), an oscillator 520 (illustrated as "OSCL"), an inverter 525, a duty rectifier 530 (illustrated as "DCRT"), and a sampler 540 (illustrated as "SMPL"). The signal generator 510 may generate a signal PST for the oscillator 520 to initiate oscillation. The signal generator 510 may transfer the signal PST to the oscillator 520. In addition, the signal generator 510 may also generate the clock signal SCK for the sampler 540 to perform the sampling. The signal generator 510 may transfer the clock signal SCK to the sampler 540.

Referring to FIG. 7, a signal generator 570 according to an embodiment may include an AND gate 571 and a delay inversion circuit 573. The AND gate 571 may perform a logical product operation on the enable signal EN and the pause signal PAUSEn to generate the signal PST. The pause signal PAUSEn may be a signal for holding the oscillation signal RO generated by the oscillator 520. The pause signal PAUSEn may hold the oscillation of the oscillation signal RO before the sampler 540 performs the sampling. When the enable signal EN has the high level, the AND gate 571 may output the pause signal PAUSEn as the signal PST. In this case, the pause signal PAUSEn may be substantially the same as the signal PST.

In some embodiments, the signal generator 570 may further include a control logic for generating the pause signal PAUSEn, or may be implemented to receive the pause signal PAUSEn from an external control logic. For example, the control logic may generate the pause signal PAUSEn having the second level while the jitter is accumulated in the oscillation signal RO, and may generate the pause signal PAUSEn having the first level after the jitter is sufficiently accumulated and before the signal DOUT is generated. The first level may be the low level, and the second level may be the high level. In response to the pause signal PAUSEn having the first level, the signal PST having the first level may be output. Accordingly, the oscillation signal RO of the oscillator 520 may not oscillate, the signal DIV of the duty rectifier 530 may be held, and the sampler 540 may stably generate the signal DOUT.

The delay inversion circuit 573 may generate the clock signal SCK based on the pause signal PAUSEn. For example, the delay inversion circuit 573 may generate the clock signal SCK by delaying and inverting the pause signal PAUSEn. The delay inversion circuit 573 may transfer the clock signal SCK to the sampler 540.

In an embodiment, the delay inversion circuit 573 may include an odd number of inverters. However, embodiments are not limited thereto, but the delay inversion circuit 573 may also be implemented as a logic circuit for delaying and inverting the pause signal PAUSEn. In some embodiments, the number of inverters included in the delay inversion circuit 573 may be implemented to be different.

Referring again to FIG. 6, the oscillator 520 may generate the oscillation signal RO in response to the signal PST having the second level. The oscillator 520 may transfer the oscillation signal RO to the inverter 525. The oscillator 520 may stop generation of the oscillation signal RO in response to the signal PST having the first level. The oscillator 520 may output a signal having the first level.

The inverter 525 may generate a signal ROn by inverting the oscillation signal RO. The inverter 525 may transfer the signal ROn to the duty rectifier 530.

The duty rectifier 530 may generate the signal DIV having a uniform duty based on the signal ROn. When the signal ROn transitions from the first level to the second level, the duty rectifier 530 may transition the state of the signal DIV. For example, the duty rectifier 530 may change the state of the signal DIV at a rising edge of the signal ROn. The duty rectifier 530 may be initialized in response to the initialization signal RSTn having the first level.

The sampler 540 may sample the signal DIV at the rising edge of the clock signal SCK. The sampler 540 may output the sampling result as the signal DOUT. The description of the duty rectifier 230 and the sampler 240 of FIG. 2 may be equally applied to the duty rectifier 530 and the sampler 540, respectively. Accordingly, redundant description may not be included herein.

Referring to FIG. 6 and FIG. 8, at a time point tb1, the enable signal EN may change from the low level to the high level. In response to the pause signal PAUSEn having the high level and the enable signal EN having the high level, the signal generator 510 may generate the signal PST having the high level. The oscillator 520 may generate the oscillation signal RO in response to the signal PST having the high level.

At a time point tb2, the oscillator 520 may transition the oscillation signal RO from the high level to the low level. The oscillator 520 may transfer the oscillation signal RO to the inverter 525. The inverter 525 may generate the signal ROn by inverting the oscillation signal RO. The inverter 525 may transfer the signal ROn to the duty rectifier 530. The duty rectifier 530 may generate the signal DIV having the high level at a time point tb3 in response to the rising edge of the signal ROn.

At a time point tb4, the pause signal PAUSEn may transition to the low level. The AND gate 571 may generate the signal PST having the low level based on the pause signal PAUSEn having the low level. The oscillator 520 may stop oscillation based on the signal PST having the low level. For example, at a time point tb5, the oscillator 520 may stop oscillation after generating the oscillation signal RO having the high level. At the time point tb5, the jitter JIT may be sufficiently accumulated in the oscillation signal RO. From the time point tb5 to a time point tb9, the oscillation signal RO may maintain the high level, and the signal ROn may maintain the low level.

At a time point tb6, the clock signal SCK may transition to the high level. The clock signal SCK may be a signal obtained as the pause signal PAUSEn is delayed and inverted. The signal generator 510 may generate the clock signal SCK by delaying and inverting the pause signal PAUSEn. For example, the edge of the pause signal PAUSEn at the time points tb4 and tb8 may correspond to the edge of the clock signal SCK at the time points tb6 and tb10.

At the time point tb6, the sampler 540 may sample the signal DIV in response to the rising edge of the clock signal SCK. Because the signal ROn maintains the low level, the signal DIV may be held at the high level and maintained until the time point tb9. Because the signal DIV is stationary, it may be ignored even if the duty rectifier 530 might have a duty problem or previous value dependency. In addition, the sampler 540 may need a setup time and a hold time for the sampling, and because the signal DIV is stationary, the time constraint of the sampler 540 may also be ensured. For example, the sampler 540 may stably perform sampling, and as a sampling result, may output the signal DOUT having the high level at a time point tb7.

When the pause signal PAUSEn reaches the high level at the time point tb8, the oscillation signal RO and the signal ROn may restart the oscillation. For example, at the time point tb9, a falling edge may occur in the oscillation signal RO, and a rising edge may occur in the signal ROn. In response to the signal ROn, the duty rectifier 530 may output the signal DIV.

After the sampler 540 performs the sampling, the initialization signal RSTn may transition to the low level. In response to the initialization signal RSTn having the low level, the duty rectifier 530 may be initialized.

In some embodiments, the oscillator 520, the duty rectifier 530, and the sampler 540 may also be implemented to operate based on the same enable signal EN and initialization signal RSTn. For example, the oscillator 520, the duty rectifier 530, and the sampler 540 may be turned on or activated based on the enable signal EN, and may be initialized based on the initialization signal RSTn.

In some embodiments, the oscillator 520, the duty rectifier 530, and the sampler 540 may operate based on the enable signal EN, and the level of the enable signal EN may transition at the same period as the sampling period. For example, the oscillator 520, the duty rectifier 530, and the sampler 540 may be periodically initialized.

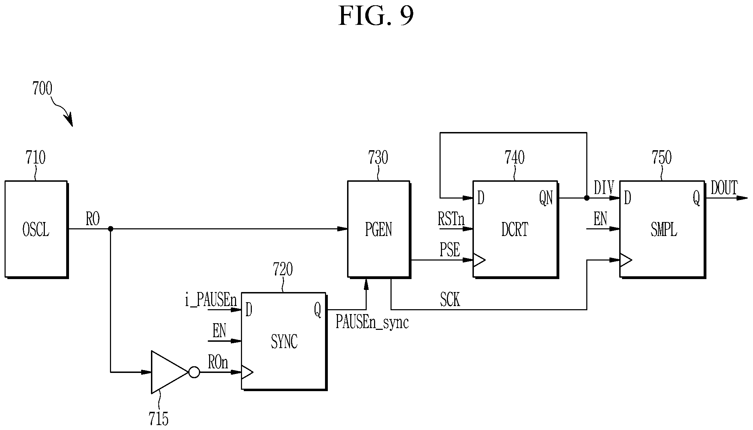

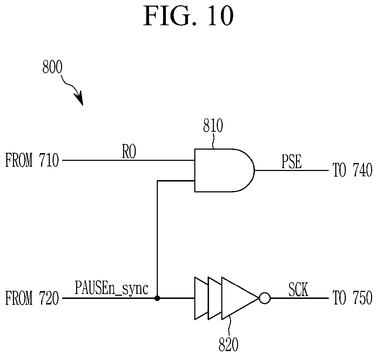

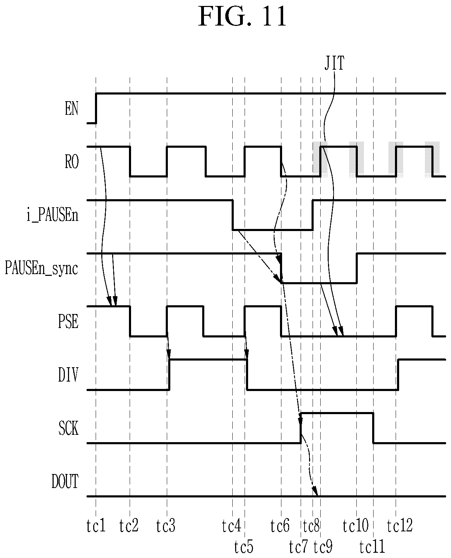

FIG. 9 is a block diagram of a TRNG according to an embodiment. FIG. 10 is a circuit diagram of a signal generator according to an embodiment. FIG. 11 is a timing diagram for explaining an operation of a TRNG according to an embodiment.

Referring to FIG. 9, a TRNG 700 according to an embodiment may generate the signal DOUT by synchronously performing the pause operation. For example, the TRNG 700 may generate the clock signal SCK synchronously with the oscillation signal RO, and may generate the signal DOUT using the clock signal SCK.

The TRNG 700 according to an embodiment may include an oscillator 710 (illustrated as "OSCL"), an inverter 715, a synchronizer 720 (illustrated as "SYNC"), a signal generator (PGEN) 730 (illustrated as "PGEN"), a duty rectifier 740 (illustrated as "DCRT"), and a sampler 750 (illustrated as "SMPL"). The description of the oscillator 210, the duty rectifier 230, and the sampler 240 of FIG. 2 may be equally applied to the oscillator 710, the duty rectifier 740, and the sampler 750. Accordingly, redundant description may not be included herein.

The oscillator 710 may generate the oscillation signal RO. The oscillator 710 may be the ring oscillator. The TRNG 700 may generate the signal DOUT based on the oscillation signal RO. The oscillator 710 may transfer the oscillation signal RO to the inverter 715 and the signal generator 730.

The inverter 715 may generate the signal ROn by inverting the oscillation signal RO. The inverter 715 may transfer the signal ROn to the synchronizer 720. The synchronizer 720 may initiate operation based on the enable signal EN. The synchronizer 720 may receive a pause signal i_PAUSEn. The synchronizer 720 may generate a signal PAUSEn_sync by sampling the pause signal i_PAUSEn based on the signal ROn.

The pause signal i_PAUSEn may be generated by the control logic. In some embodiments, the control logic may be disposed inside or outside TRNG 700. For example, the control logic may generate the pause signal i_PAUSEn having the second level while the jitter is accumulated in the oscillation signal RO, and may generate the pause signal i_PAUSEn having the first level after the jitter is sufficiently accumulated and before the signal DOUT is generated. As discussed above, the first level may be a low level, and the second level may be a high level. The synchronizer 720 may sample the pause signal i_PAUSEn in response to the rising edge of the signal ROn. For example, the synchronizer 720 may sample the pause signal i_PAUSEn at the falling edge of the oscillation signal RO. The synchronizer 720 may transfer the signal PAUSEn_sync to the signal generator 730.

The signal generator 730 may receive the oscillation signal RO and the signal PAUSEn_sync. The signal generator 730 may generate the signal PSE and the clock signal SCK based on the oscillation signal RO and the signal PAUSEn_sync. The signal generator 730 may transfer the signal PSE to the duty rectifier 740, and transfer the clock signal SCK to the sampler 750.

Referring to FIG. 10, a signal generator 800 according to an embodiment may receive the oscillation signal RO from the oscillator 710, and receive the signal PAUSEn_sync from the synchronizer 720. The signal generator 800 may include an AND gate 810 and a delay inversion circuit 820. The AND gate 810 may generate the signal PSE by performing a logical product operation on the oscillation signal RO and the signal PAUSEn_sync.

The signal PAUSEn_sync may be a signal for holding the oscillation signal RO. The signal PAUSEn_sync may hold the oscillation of the oscillation signal RO before the sampler 750 performs the sampling. When the signal PAUSEn_sync is the high level, the AND gate 810 may output the oscillation signal RO as the signal PSE. In this case, the oscillation signal RO may be substantially the same as the signal PSE.

The delay inversion circuit 820 may generate the clock signal SCK based on the signal PAUSEn_sync. For example, the delay inversion circuit 820 may generate the clock signal SCK by delaying and inverting the signal PAUSEn_sync. The delay inversion circuit 820 may transfer the clock signal SCK to the sampler 750.

In an embodiment, the delay inversion circuit 820 may include the odd number of inverters. However, embodiments are not limited thereto, but the delay inversion circuit 820 may also be implemented as a logic circuit for delaying and inverting the signal PAUSEn_sync. In some embodiments, the number of inverters included in the delay inversion circuit 820 may be implemented to be different.

Referring again to FIG. 9, the duty rectifier 740 may generate the signal DIV having a uniform duty based on the signal PSE. When the signal PSE transitions from the first level to the second level, the duty rectifier 740 may transition the state of the signal DIV. For example, the duty rectifier 740 may change the state of the signal DIV at the rising edge of the signal PSE. The duty rectifier 740 may be initialized in response to the initialization signal RSTn having the first level.

The sampler 750 may sample the signal DIV at the rising edge of the clock signal SCK. The sampler 750 may output the sampling result as the signal DOUT. The description of the duty rectifier 230 and the sampler 240 of FIG. 2 may be equally applied to the duty rectifier 740 and the sampler 750. Accordingly, redundant description may not be included herein.

Referring to FIG. 9 and FIG. 11, at a time point tc1, the enable signal EN may change from the low level to the high level. The oscillator 710 and the sampler 750 may initiate operation in response to the enable signal EN having the high level.

At a time point tc2, the oscillator 710 may transition the oscillation signal RO from the high level to the low level. The oscillator 710 may transfer the oscillation signal RO to the inverter 715. The inverter 715 may generate the signal ROn by inverting the oscillation signal RO. The inverter 715 may transfer the signal ROn to the synchronizer 720. The pause signal i_PAUSEn may be at the high level until a time point tc4. The pause signal i_PAUSEn may be at the low level from the time point tc4 to a time point tc8. In response to the pause signal i_PAUSEn, the signal PAUSEn_sync may be at the low level from a time point tc6 to a time point tc10.

The synchronizer 720 may output the signal PAUSEn_sync having the high level until the time point tc6 based on the pause signal i_PAUSEn having the high level. At the time point tc6, the synchronizer 720 may output the signal PAUSEn_sync having the low level by sampling the pause signal i_PAUSEn in response to the falling edge of the oscillation signal RO. Due to the signal PAUSEn_sync having the low level, at a time point tc9, even if the oscillation signal RO becomes the high level, the signal PSE may maintain the low level. The jitter JIT may be sufficiently accumulated in the oscillation signal RO. In addition, at the time point tc10, the synchronizer 720 may output the signal PAUSEn_sync having the high level by sampling the pause signal i_PAUSEn in response to the falling edge of the oscillation signal RO. In response to the signal PAUSEn_sync having the high level, a rising edge of the oscillation signal RO of a time point tc12 may cause the rising edge of the signal PSE and the signal DIV.

At a time point tc3, in response to the rising edge of the signal PSE, the duty rectifier 740 may output the signal DIV having the high level. In addition, at a time point tc5, in response to the rising edge of the signal PSE, the duty rectifier 740 may output the signal DIV having the low level.

The signal generator 730 may generate the clock signal SCK based on the signal PAUSEn_sync. The falling edge of the signal PAUSEn_sync at the time point tc6 may cause the rising edge of the clock signal SCK at a time point tc7. The clock signal SCK may maintain the high level from the time point tc7 to a time point tc11. The sampler 750 may sample the signal DIV in response to the rising edge of the clock signal SCK. The sampler 750 may output the sampling result having a value of zero ("0") as the signal DOUT.

After the sampler 750 performs the sampling, the initialization signal RSTn may transition to the low level. In response to the initialization signal RSTn having the low level, the duty rectifier 740 may be initialized.

In some embodiments, the oscillator 710, the duty rectifier 740, and the sampler 750 may also be implemented to operate based on the same enable signal EN and initialization signal RSTn. For example, the oscillator 710, the duty rectifier 740, and the sampler 750 may be turned on or activated based on the enable signal EN, and may be initialized based on the initialization signal RSTn.

In some embodiments, the oscillator 710, the duty rectifier 740, and the sampler 750 may operate based on the enable signal EN, and the level of the enable signal EN may transition at the same period as the sampling period. For example, the oscillator 710, the duty rectifier 740, and the sampler 750 may be periodically initialized.

As such, the TRNG 700 may change the state of the signal DIV at the rising edge of the oscillation signal RO, and may output the signal DOUT by holding and sampling the signal DIV at the falling edge of the oscillation signal RO. Due to the duty rectifier 740, the duty problem of the oscillator 710 may be solved. Because the signal DIV may be stationary due to the synchronizer 720 and the signal PAUSEn_sync, it may be ignored even if the duty rectifier 740 might have a duty problem or previous value dependency. In addition, because the signal DIV is stationary, the time constraint of the sampler 750 may be ensured, and the sampler 750 may stably perform sampling.

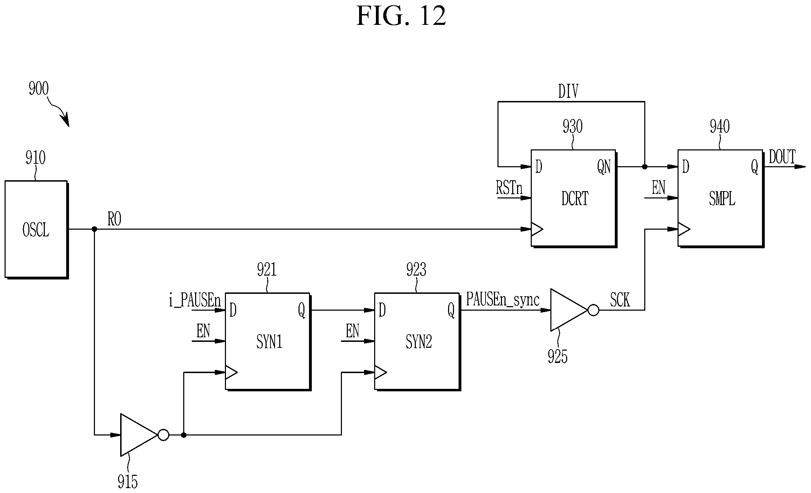

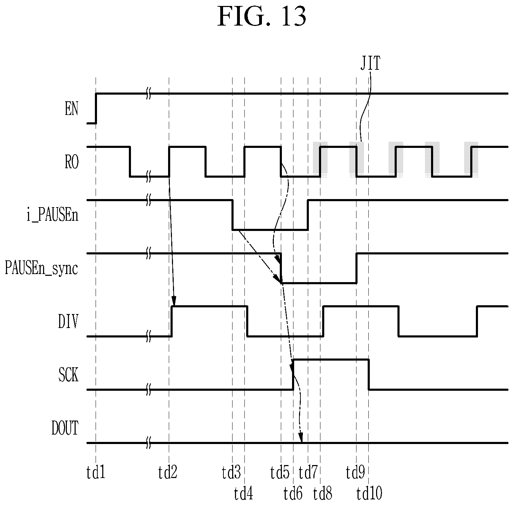

FIG. 12 is a block diagram of a TRNG according to an embodiment. FIG. 13 is a timing diagram for explaining an operation of a TRNG according to an embodiment.

Referring to FIG. 12 and FIG. 13, a TRNG 900 according to an embodiment may generate the signal DOUT by synchronously performing the pause operation. For example, the TRNG 900 may generate the clock signal SCK synchronously with the oscillation signal RO, and may generate the signal DOUT using the clock signal SCK.

The TRNG 900 according to an embodiment may include an oscillator 910 (illustrated as "OSCL"), a first inverter 915, a first synchronizer (SYN1) 921, a second synchronizer (SYN2) 923, a second inverter 925, a duty rectifier 930 (illustrated as "DCRT"), and a sampler 940 (illustrated as "SMPL"). The description of the oscillator 210, the duty rectifier 230, and the sampler 240 of FIG. 2 may be equally applied to the oscillator 910, the duty rectifier 930, and the sampler 940. Accordingly, redundant description may not be included herein.

When the enable signal EN changes from the low level to the high level at a time point td1, the oscillator 910 may generate the oscillation signal RO. The oscillator 910 may be the ring oscillator. The TRNG 900 may generate the signal DOUT based on the oscillation signal RO. The oscillator 910 may transfer the oscillation signal RO to the first inverter 915 and the duty rectifier 930.

The first inverter 915 may generate an inversion signal by inverting the oscillation signal RO. The first inverter 915 may transfer the inversion signal to the first synchronizer 921 and the second synchronizer 923. The first synchronizer 921 and the second synchronizer 923 may initiate operation based on the enable signal EN. The first synchronizer 921 may receive the pause signal i_PAUSEn. The pause signal i_PAUSEn may be generated by the control logic. In some embodiments, the control logic may be disposed inside or outside TRNG 900. For example, the control logic may generate the pause signal i_PAUSEn having the second level while the jitter JIT is accumulated in the oscillation signal RO, and may generate the pause signal i_PAUSEn having the first level after the jitter JIT is sufficiently accumulated and before the signal DOUT is generated. As discussed above, the first level may be a low level, and the second level may be a high level.

The first synchronizer 921 may generate a synchronization signal by sampling the pause signal i_PAUSEn in response to a rising edge of the inversion signal. For example, the first synchronizer 921 may sample the pause signal i_PAUSEn at the falling edge of the oscillation signal RO. The first synchronizer 921 may transfer the synchronization signal to the second synchronizer 923. The second synchronizer 923 may generate the signal PAUSEn_sync by sampling the synchronization signal based on the inversion signal.

At a time point td3, the pause signal i_PAUSEn may have a falling edge. In response to the pause signal i_PAUSEn having the low level, at a time point td5, the first synchronizer 921 and the second synchronizer 923 may generate the signal PAUSEn_sync having the low level. The pause signal i_PAUSEn having the low level from the time point td3 to a time point td7 may correspond to the signal PAUSEn_sync having the low level from the time point td5 to a time point td9.

The inverter 925 may generate the clock signal SCK by inverting the signal PAUSEn_sync. The inverter 925 may delay and invert the signal PAUSEn_sync. In some embodiments, the inverter 925 may also be implemented as a plural quantity. At the time point td5, the falling edge of the signal PAUSEn_sync may correspond to the rising edge of the clock signal SCK at a time point td6. The signal PAUSEn_sync having the low level from the time point td5 to the time point td9 may correspond to the clock signal SCK having the high level from the time point td6 to a time point td10.

The duty rectifier 930 may generate the signal DIV having a uniform duty based on the oscillation signal RO. When the oscillation signal RO transitions from the first level to the second level, the duty rectifier 930 may transition the state of the signal DIV. For example, the duty rectifier 930 may change the state of the signal DIV at the rising edge of the oscillation signal RO. At a time point td2 and a time point td4, in response to the rising edge of the oscillation signal RO, the signal DIV may each have a rising edge and falling edge. At a time point td8, in response to the rising edge of the oscillation signal RO, the signal DIV may have a rising edge. The jitter JIT may be sufficiently accumulated in the oscillation signal RO. The duty rectifier 930 may be initialized in response to the initialization signal RSTn having the first level.

At the time point td6, the sampler 940 may sample the signal DIV in response to the rising edge of the clock signal SCK. Because the signal DIV remains at the low level, the sampler 940 may output the signal DOUT having the low level as the sampling result. The description of the duty rectifier 230 and the sampler 240 of FIG. 2 may be equally applied to the duty rectifier 930 and the sampler 940. Accordingly, redundant description may not be included herein.

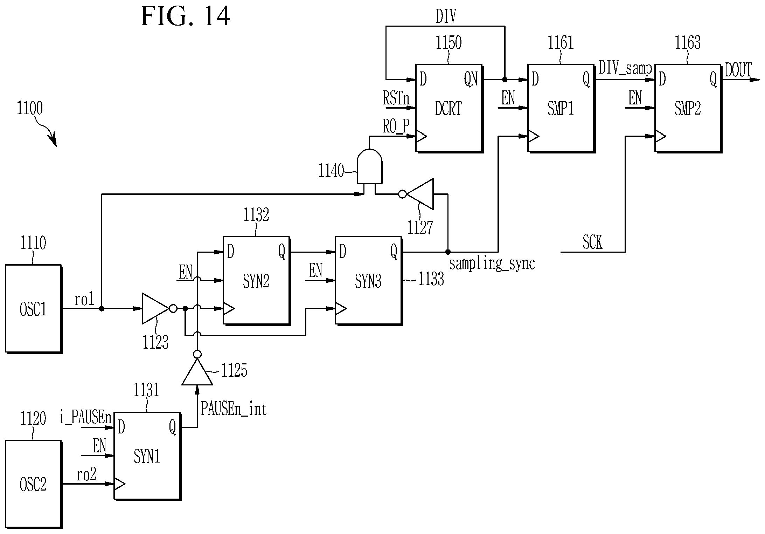

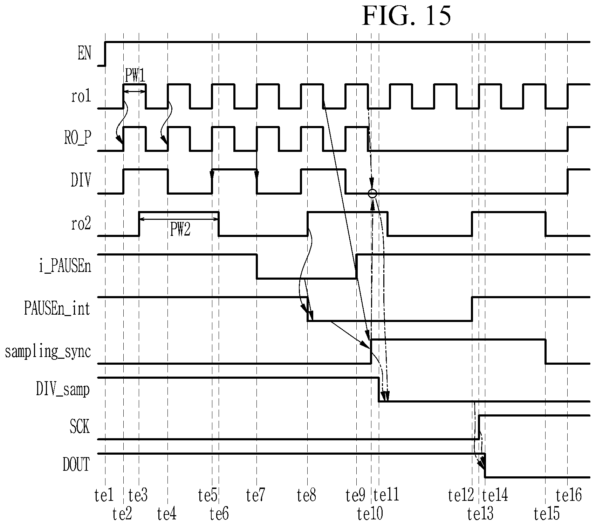

FIG. 14 is a block diagram of a TRNG according to an embodiment. FIG. 15 is a timing diagram for explaining an operation of a TRNG according to an embodiment.

Referring to FIG. 14, a TRNG 1100 according to an embodiment may generate the signal DOUT by synchronously performing the pause operation. For example, the TRNG 1100 may generate a clock signal sampling_sync synchronously with the oscillation signals ro1 and ro2, and may generate the signal DIV_samp using the clock signal sampling_sync.

The TRNG 1100 according to an embodiment may include an oscillator 1110 (illustrated as "OSC1"), an oscillator 1120 (illustrated as "OSC2"), an inverter 1123, an inverter 1125, an inverter 1127, a synchronizer 1131 (illustrated as "SYN1"), a synchronizer 1132 (illustrated as "SYN2"), a synchronizer 1133 (illustrated as "SYN3"), an AND gate 1140, a duty rectifier 1150 (illustrated as "DCRT"), a sampler 1161 (illustrated as "SMP1"), and a sampler 1163 (illustrated as "SMP2").

Referring to FIG. 14 and FIG. 15, when the enable signal EN changes from the low level to the high level at a time point te1, oscillators 1110 and 1120 may generate the oscillation signals ro1 and ro2. The oscillators 1110 and 1120 may be the ring oscillator. The TRNG 1100 may generate the signal DOUT based on the oscillation signals ro1 and ro2. In addition, in response to the enable signal EN having the high level, the synchronizers 1131 to 1133, the duty rectifier 1150, and the samplers 1161 and 1163 may initiate operation.

A first oscillator 1110 may generate a first oscillation signal ro1 and transfer it to a first inverter 1123 and the AND gate 1140. A second oscillator 1120 may generate a second oscillation signal ro2 and transfer it to a first synchronizer 1131. For example, the first oscillator 1110 may generate the oscillation signal ro1 having the high level from a time point te2.

The first oscillation signal ro1 of the first oscillator 1110 and the second oscillation signal ro2 of the second oscillator 1120 are different from each other in at least one of the pulse width and the frequency. For example, the first oscillation signal ro1 may have the pulse width of PW1, and the second oscillation signal ro2 may have the pulse width of PW2. The second oscillator 1120 may generate the oscillation signal ro2 having the high level from a time point te3 to a time point te6. In an embodiment, the number of inverters included in the first oscillator 1110 and the number of inverters included in the second oscillator 1120 may be different.

The first inverter 1123 may generate a first inversion signal by inverting the first oscillation signal ro1. The first inverter 1123 may transfer the first inversion signal to a second synchronizer 1132 and a third synchronizer 1133. The first inversion signal may have a phase opposite to the first oscillation signal ro1. For example, the first inversion signal may have a falling edge at a rising edge of the first oscillation signal ro1, and the first inversion signal may have a rising edge at a falling edge of the first oscillation signal ro1.

The first synchronizer 1131 may receive the pause signal i_PAUSEn. The pause signal i_PAUSEn may be generated by the control logic. In some embodiments, the control logic may be disposed inside or outside TRNG 1100. For example, the control logic may generate the pause signal i_PAUSEn having the second level while the jitter is accumulated in the oscillation signals ro1 and ro2, and may generate the pause signal i_PAUSEn having the first level after the jitter is sufficiently accumulated and before the signal DOUT is generated. As discussed above, the first level may be a low level, and the second level may be a high level.

The first synchronizer 1131 may generate a signal PAUSEn_int by sampling the pause signal i_PAUSEn in response to a rising edge of the second oscillation signal ro2. The first synchronizer 1131 may transfer the signal PAUSEn_int to a second inverter 1125. The second inverter 1125 may generate the second inversion signal by inverting the signal PAUSEn_int. The second inverter 1125 may transfer the second inversion signal to the second synchronizer 1132.

At a time point te7, the pause signal i_PAUSEn may maintain the low level until a time point te9, and may be at the high level from the time point te9. At a time point te8, the first synchronizer 1131 may generate the signal PAUSEn_int having the low level by sampling the pause signal i_PAUSEn in response to the rising edge of the second oscillation signal ro2. At a time point te12, the first synchronizer 1131 may generate the signal PAUSEn_int having the high level by sampling the pause signal i_PAUSEn in response to the rising edge of the second oscillation signal ro2.

The second synchronizer 1132 may sample the second inversion signal based on the first inversion signal. The second synchronizer 1132 may generate the synchronization signal by sampling the second inversion signal at a rising edge of the first inversion signal. The second synchronizer 1132 may transfer the synchronization signal to the third synchronizer 1133.

The third synchronizer 1133 may sample the synchronization signal based on the first inversion signal. The third synchronizer 1133 may generate the signal sampling_sync by sampling the synchronization signal at the rising edge of the first inversion signal. The third synchronizer 1133 may transfer the signal sampling_sync to a third inverter 1127 and a first sampler 1161.

In some embodiments, the second synchronizer 1132 and the third synchronizer 1133 may also be implemented as one synchronizer. One synchronizer may generate the signal sampling_sync by sampling the second inversion signal based on the first inversion signal.

The third inverter 1127 may generate a third inversion signal by inverting the signal sampling_sync. The third inverter 1127 may transfer the third inversion signal to the AND gate 1140.

The AND gate 1140 may generate a signal RO_P by performing a logical product operation on the first oscillation signal ro1 and the third inversion signal. For example, the AND gate 1140 may output the first oscillation signal ro1 as the signal RO_P in response to the third inversion signal having the second level. The AND gate 1140 may transfer the signal RO_P to the duty rectifier 1150. The AND gate 1140 may output signal having the low level in response to the third inversion signal having the low level. In this case, the duty rectifier 1150 may receive a signal that does not oscillate.

At a time point te10, in response to the third inversion signal having the low level, the signal RO_P may not oscillate. For example, the signal RO_P may not oscillate in response to the signal sampling_sync having the high level. The signal sampling_sync may maintain the high level from the time point te10 to a time point te15, and the signal RO_P may maintain the low level from the time point te10 to a time point te16. The signal DIV may maintain the low level until the time point te16 at which the signal RO_P changes to the high level. At the time point te16, the signal DIV may have a rising edge in response to the signal RO_P having the high level.

The duty rectifier 1150 may generate the signal DIV based on the signal RO_P. For example, the duty rectifier 1150 may change the state of the signal DIV in response to a rising edge of the signal RO_P. The duty rectifier 1150 may transfer the signal DIV to the first sampler 1161. At time points te2 and te5, the duty rectifier 1150 may generate the signal DIV having the high level in response to the rising edge of the signal RO_P. At time points te4 and te7, the duty rectifier 1150 may generate the signal DIV having the low level in response to the rising edge of the signal RO_P.

The first sampler 1161 may sample the signal DIV based on the signal sampling_sync and generate the signal DIV_samp. At the time point te10, the first sampler 1161 may sample the signal DIV in response to a rising edge of the signal sampling_sync, and may generate the signal DIV_samp having the low level at a time point te11. The first sampler 1161 may transfer the signal DIV_samp to a second sampler 1163. In some embodiments, the TRNG 1100 may use the signal DIV_samp as the random bit. In this case, the TRNG 1100 may not include the second sampler 1163.

The second sampler 1163 may sample the signal DIV_samp based on the clock signal SCK, and generate the signal DOUT. At a time point te13, the second sampler 1163 may sample the signal DIV_samp in response to rising the edge of the clock signal SCK, and may generate the signal DOUT having the low level at a time point te14. In an embodiment, the clock signal SCK may be generated by the control logic. For example, the control logic may generate the clock signal SCK based on the pause signal i_PAUSEn. The control logic may generate the clock signal SCK by delaying and inverting the pause signal i_PAUSEn.

The TRNG 1100 according to an embodiment may operate by combining the jitter of the first oscillator 1110 and the jitter of the second oscillator 1120, and therefore, the time for sufficiently accumulating the jitter may be shortened. Accordingly, the time used by the TRNG 1100 to generate the signal DOUT may be shortened. In addition, the duty problem of the oscillators 1110 and 1120 and the duty rectifier 1150 may be solved, and the time constraint of the samplers 1161 and 1163 may be ensured. This may improve performance.

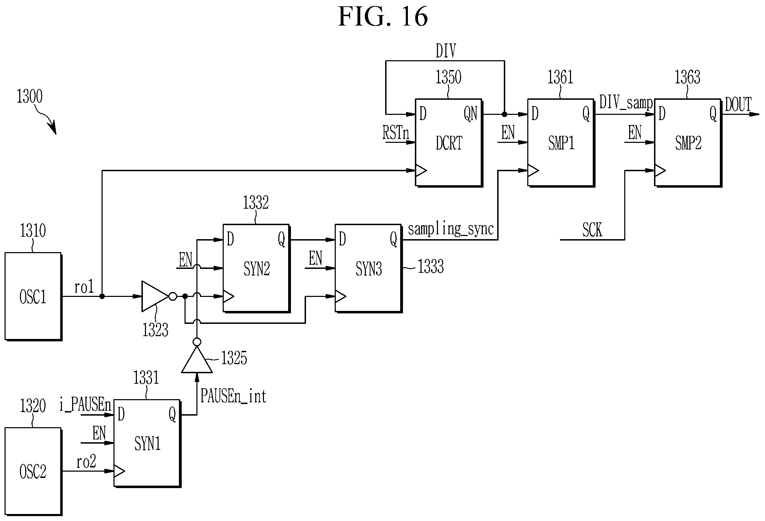

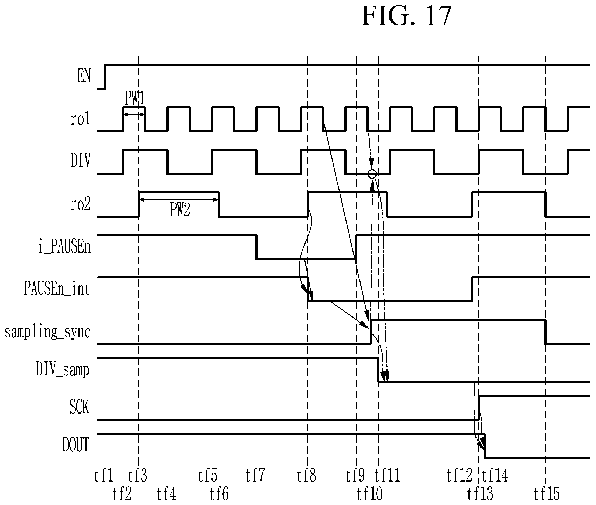

FIG. 16 is a block diagram of a TRNG according to an embodiment. FIG. 17 is a timing diagram for explaining an operation of a TRNG according to an embodiment.

Referring to FIG. 16, a TRNG 1300 according to an embodiment may generate the signal DOUT by synchronously performing the pause operation. For example, the TRNG 1300 may generate the clock signal sampling_sync synchronously with the oscillation signals ro1 and ro2, and may generate the signal DIV_samp using the clock signal sampling_sync.

The TRNG 1300 according to an embodiment may include an oscillator 1310 (illustrated as "OSC1"), an oscillator 1320 (illustrated as "OSC2"), an inverter 1323, an inverter 1325, a synchronizer 1331 (illustrated as "SYN1"), a synchronizer 1332 (illustrated as "SYN2"), a synchronizer 1333 (illustrated as "SYN3"), a duty rectifier1350 (illustrated as "DCRT"), a sampler 1361 (illustrated as "SMP1"), and a sampler 1363 (illustrated as "SMP2").

Referring to FIG. 16 and FIG. 17, when the enable signal EN changes from the low level to the high level at a time point tf1, the oscillators 1310 and 1320 may generate the oscillation signals ro1 and ro2. The oscillators 1310 and 1320 may be the ring oscillator. The TRNG 1300 may generate the signal DOUT based on the oscillation signals ro1 and ro2. In addition, in response to the enable signal EN having the high level, synchronizers 1331 to 1333, the duty rectifier 1350, and samplers 1361 and 1363 may initiate operation.

The first oscillator 1310 may generate the first oscillation signal ro1 and transfer it to a first inverter 1323 and the duty rectifier 1350. The second oscillator 1320 may generate the second oscillation signal ro2 and transfer it to a first synchronizer 1331. For example, the first oscillator 1310 may generate the oscillation signal ro1 having the high level from a time point tf2.

The first oscillation signal ro1 of the first oscillator 1310 and the second oscillation signal ro2 of the second oscillator 1320 are different from each other in at least one of the pulse width and the frequency. For example, the first oscillation signal ro1 may have the pulse width of PW1, and the second oscillation signal ro2 may have the pulse width of PW2. The second oscillator 1320 may generate the oscillation signal ro2 having the high level from a time point tf3 to a time point tf6. In an embodiment, the number of inverters included in the first oscillator 1310 and the number of inverters included in the second oscillator 1320 may be different.

The first inverter 1323 may generate the first inversion signal by inverting the first oscillation signal ro1. The first inverter 1323 may transfer the first inversion signal to a second synchronizer 1332 and a third synchronizer 1333. The first inversion signal may have a phase opposite to the first oscillation signal ro1. For example, the first inversion signal may have a falling edge at the rising edge of the first oscillation signal ro1, and the first inversion signal may have a rising edge at the falling edge of the first oscillation signal ro1.

The first synchronizer 1331 may receive the pause signal i_PAUSEn. The pause signal i_PAUSEn may be generated by the control logic. In some embodiments, the control logic may be disposed inside or outside TRNG 1300. For example, the control logic may generate the pause signal i_PAUSEn having the second level while the jitter is accumulated in the oscillation signals ro1 and ro2, and may generate the pause signal i_PAUSEn having the first level after the jitter is sufficiently accumulated and before the signal DOUT is generated. As discussed above, the first level may be a low level, and the second level may be a high level.

The first synchronizer 1331 may generate the signal PAUSEn_int by sampling the pause signal i_PAUSEn in response to the rising edge of the second oscillation signal ro2. The first synchronizer 1331 may transfer the signal PAUSEn_int to a second inverter 1325. The second inverter 1325 may generate the second inversion signal by inverting the signal PAUSEn_int. The second inverter 1325 may transfer the second inversion signal to the second synchronizer 1332.

At a time point tf7, the pause signal i_PAUSEn may maintain the low level until a time point tf9, and may be at the high level from the time point tf9. At a time point tf8, the first synchronizer 1331 may generate the signal PAUSEn_int having the low level by sampling the pause signal i_PAUSEn in response to the rising edge of the second oscillation signal ro2. At a time point tf12, the first synchronizer 1331 may generate the signal PAUSEn_int having the high level by sampling the pause signal i_PAUSEn in response to the rising edge of the second oscillation signal ro2.

The second synchronizer 1332 may sample the second inversion signal based on the first inversion signal. The second synchronizer 1332 may generate the synchronization signal by sampling the second inversion signal at the rising edge of the first inversion signal. The second synchronizer 1332 may transfer the synchronization signal to the third synchronizer 1333.

The third synchronizer 1333 may sample the synchronization signal based on the first inversion signal. The third synchronizer 1333 may generate the signal sampling_sync by sampling the synchronization signal at the rising edge of the first inversion signal. The third synchronizer 1333 may transfer the signal sampling_sync to a first sampler 1361. The signal sampling_sync may maintain the high level from a time point tf10 to a time point tf15. The signal sampling_sync may be at the low level from the time point tf15.

In some embodiments, the second synchronizer 1332 and the third synchronizer 1333 may also be implemented as one synchronizer. One synchronizer may generate the signal sampling_sync by sampling the second inversion signal based on the first inversion signal.

The duty rectifier 1350 may generate the signal DIV based on the first oscillation signal ro1. For example, the duty rectifier 1350 may change the state of the signal DIV in response to the rising edge of the first oscillation signal ro1. The duty rectifier 1350 may transfer the signal DIV to the first sampler 1361. At the time points tf2 and tf5, the duty rectifier 1350 may generate the signal DIV having the high level in response to the rising edge of the first oscillation signal ro1. At time points tf4 and tf7, the duty rectifier 1350 may generate the signal DIV having the low level in response to the rising edge of the first oscillation signal ro1.

The first sampler 1361 may sample the signal DIV based on the signal sampling_sync and generate the signal DIV_samp. At the time point tf10, the first sampler 1361 may sample the signal DIV in response to the rising edge of the signal sampling_sync, and may generate the signal DIV_samp having the low level at a time point tf11. The first sampler 1361 may transfer the signal DIV_samp to a second sampler 1363. In some embodiments, the TRNG 1300 may use the signal DIV_samp as the random bit. In this case, the TRNG 1300 may not include the second sampler 1363.

The second sampler 1363 may sample the signal DIV_samp based on the clock signal SCK, and generate the signal DOUT. At a time point tf13, the second sampler 1363 may sample the signal DIV_samp in response to rising the edge of the clock signal SCK, and may generate the signal DOUT having the low level at a time point tf14. In an embodiment, the clock signal SCK may be generated by the control logic. For example, the control logic may generate the clock signal SCK based on the pause signal i_PAUSEn. The control logic may generate the clock signal SCK by delaying and inverting the pause signal i_PAUSEn.

The TRNG 1300 according to an embodiment may operate by combining the jitter of the first oscillator 1310 and the jitter of the second oscillator 1320, and therefore, the time for sufficiently accumulating the jitter may be shortened. Accordingly, the time used by the TRNG 1300 to generate the signal DOUT may be shortened. In addition, the duty problem of the oscillators 1310 and 1320 and the duty rectifier 1350 may be solved, and the time constraint of the samplers 1361 and 1363 may be ensured.

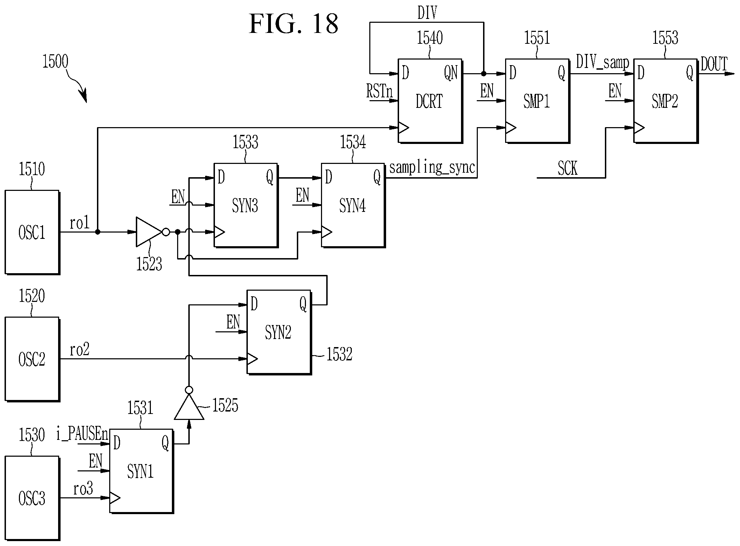

FIG. 18 is a block diagram of a TRNG according to an embodiment.

Referring to FIG. 18, a TRNG 1500 according to an embodiment may generate the signal DOUT by synchronously performing the pause operation. For example, the TRNG 1500 may generate the clock signal sampling_sync synchronously with the oscillation signal ro1, ro2, and ro3, and may generate the signal DIV_samp using the clock signal sampling_sync.

The TRNG 1500 according to an embodiment may include an oscillator 1510 (illustrated as "OSC1"), an oscillator 1520 (illustrated as "OSC2"), an oscillator 1530 (illustrated as "OSC3"), an inverter 1523, an inverter 1525, a synchronizer 1531 (illustrated as "SYN1"), a synchronizer 1532 (illustrated as "SYN2"), a synchronizer 1533 (illustrated as "SYN3"), and synchronizer 1534 (illustrated as "SYN4"), duty rectifier (DCRT) 1540, a sampler 1551 (illustrated as "SMP1"), and a sampler 1553 (illustrated as "SMP2"). The description of the duty rectifier 1350 and the samplers 1361 and 1363 of FIG. 16 may be equally applied to the duty rectifier 1540 and samplers 1551 and 1553. Accordingly, redundant description may not be included herein.

When the enable signal EN changes from the low level to the high level, the oscillators 1510 to 1530 may generate the oscillation signal ro1, ro2, and ro3. The oscillators 1510 to 1530 may be the ring oscillator. The TRNG 1500 may generate the signal DOUT based on the oscillation signal ro1, ro2, and ro3. In addition, in response to the enable signal EN having the high level, synchronizers 1531 to 1534, the duty rectifier 1540, and the samplers 1551 and 1553 may initiate operation.

A first oscillator 1510 may generate the first oscillation signal ro1 and transfer it to a first inverter 1523 and the duty rectifier 1540. A second oscillator 1520 may generate the second oscillation signal ro2 and transfer it to a second synchronizer 1532. A third oscillator 1530 may generate a third oscillation signal ro3 and transfer it to a first synchronizer 1531.

The oscillation signal ro1, ro2, and ro3 are different from each other in at least one of the pulse width and the frequency. For example, the first oscillation signal ro1 may have a first pulse width, and the second oscillation signal ro2 may have a second pulse width, and the third oscillation signal ro3 may have a third pulse width. In an embodiment, the number of inverters included in the oscillators 1510 to 1530 may be all different.

The first inverter 1523 may generate the first inversion signal by inverting the first oscillation signal ro1. The first inverter 1523 may transfer the first inversion signal to a third synchronizer 1533 and a fourth synchronizer 1534. The first inversion signal may have a phase opposite to the first oscillation signal ro1. For example, the first inversion signal may have a falling edge at the rising edge of the first oscillation signal ro1, and the first inversion signal may have a rising edge at the falling edge of the first oscillation signal ro1.

The first synchronizer 1531 may receive the pause signal i_PAUSEn. The pause signal i_PAUSEn may be generated by the control logic. In some embodiments, the control logic may be disposed inside or outside TRNG 1500. For example, the control logic may generate the pause signal i_PAUSEn having the second level while the jitter is accumulated in the oscillation signal ro1, ro2, and ro3, and may generate the pause signal i_PAUSEn having the first level after the jitter is sufficiently accumulated and before the signal DOUT is generated. As discussed above, the first level may be a low level, and the second level may be a high level.

The first synchronizer 1531 may generate a first synchronization signal by sampling the pause signal i_PAUSEn in response to a rising edge of the third oscillation signal ro3. The first synchronizer 1531 may transfer the first synchronization signal to a second inverter 1525. The second inverter 1525 may generate the second inversion signal by inverting the first synchronization signal. The second inverter 1525 may transfer the second inversion signal to the second synchronizer 1532.

The second synchronizer 1532 may sample the second inversion signal based on the second oscillation signal ro2. The second synchronizer 1532 may generate a second synchronization signal by sampling the second inversion signal at the rising edge of the second oscillation signal ro2. The second synchronizer 1532 may transfer the second synchronization signal to the third synchronizer 1533.

The third synchronizer 1533 may sample the second synchronization signal based on the first inversion signal. The third synchronizer 1533 may generate third synchronization signal by sampling the second synchronization signal at the rising edge of the first inversion signal. The third synchronizer 1533 may transfer third synchronization signal to the fourth synchronizer 1534.

The fourth synchronizer 1534 may sample third synchronization signal based on the first inversion signal. The fourth synchronizer 1534 may generate the signal sampling_sync by sampling third synchronization signal at the rising edge of the first inversion signal. The fourth synchronizer 1534 may transfer the signal sampling_sync to a first sampler 1551.

In some embodiments, the third synchronizer 1533 and the fourth synchronizer 1534 may also be implemented as one synchronizer. One synchronizer may generate the signal sampling_sync by sampling the second synchronization signal based on the first inversion signal.

The duty rectifier 1540 may generate the signal DIV based on the first oscillation signal ro1. For example, the duty rectifier 1540 may change the state of the signal DIV in response to the rising edge of the first oscillation signal ro1. The duty rectifier 1540 may transfer the signal DIV to the first sampler 1551.

The first sampler 1551 may sample the signal DIV based on the signal sampling_sync and generate the signal DIV_samp. The first sampler 1551 may transfer the signal DIV_samp to a second sampler 1553. In some embodiments, the TRNG 1500 may use the signal DIV_samp as the random bit. In this case, the TRNG 1500 may not include the second sampler 1553.

The second sampler 1553 may sample the signal DIV_samp based on the clock signal SCK, and generate the signal DOUT. In an embodiment, the clock signal SCK may be generated by the control logic. For example, the control logic may generate the clock signal SCK based on the pause signal i_PAUSEn. The control logic may generate the clock signal SCK by delaying and inverting the pause signal i_PAUSEn.

The TRNG 1500 according to an embodiment operates by combining the jitter of the oscillators 1510 to 1530, and therefore, the time for sufficiently accumulating the jitter may be shortened. Accordingly, the time used by the TRNG 1500 to generate the signal DOUT may be shortened. In addition, the duty problem of the oscillators 1510 to 1530 and the duty rectifier 1540 may be solved, and the time constraint of the samplers 1551 and 1553 may be ensured.

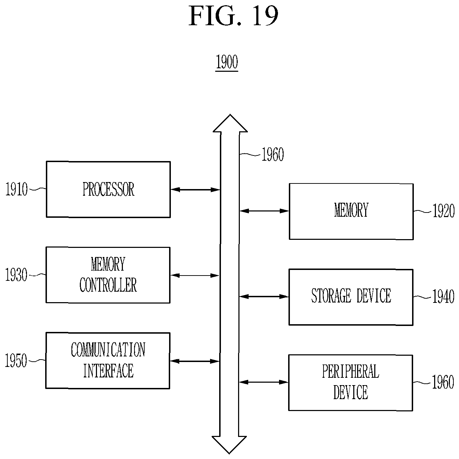

FIG. 19 is a block diagram of a computing system according to an embodiment.

Referring to FIG. 19, a computing system 1900 according to an embodiment may include a processor 1910, a memory 1920, a memory controller 1930, a storage device 1940, a communication interface 1950, a peripheral device 1960, and a bus 1970. The computing system 1900 may further include other general-purposed components.

The processor 1910 may control the overall operation of respective components of the computing system 1900. The processor 1910 may be implemented as at least one of various processing units such as CPU, AP, GPU, or the like.

The processor 1910 may include a TRNG described with reference to FIG. 1 to FIG. 18. In some embodiments, TRNG may also be disposed in an exterior of the processor 1910.

The TRNG may include an oscillator, signal generator, duty rectifier, and sampler in order to generate a random number. The signal generator may generate a pause signal for stopping the oscillation of the oscillation signal generated by the oscillator and a clock signal for sampling of the sampler. The signal generator may generate the pause signal synchronously or asynchronously with the oscillation signal. Accordingly, the duty problem of the oscillator and the duty rectifier may be solved, and the time constraint of the sampler may be ensured. In some embodiments, TRNG may also include a plurality of oscillators.

The random number output by the TRNG may be transferred to and used by at least one of the memory 1920, the memory controller 1930, the storage device 1940, the communication interface 1950, a peripheral device 1960, and the bus 1970.

The memory 1920 may store data and instructions. The memory controller 1930 may control the transfer of data or instructions to and from the memory 1920. In some embodiments, the memory controller 1930 may be provided as a separate chip from the processor 1910. In some embodiments, the memory controller 1930 may be provided as an internal component of the processor 1910.

The storage device 1940 may non-temporarily store programs and data. In an embodiment, the storage device 1940 may be implemented as a nonvolatile memory. The communication interface 1950 may support the wired/wireless Internet communication of the computing system 1900. In addition, the communication interface 1950 may also support various communication schemes other than the Internet communication.

The peripheral device 1960 according to an embodiment may be a device configured to convert a motion picture a still image, or the like, to an electrical signal, such as a camera, a scanner, a webcam, or the like, or a display device. In an embodiment, the image data obtained through the peripheral device 1960 may be stored in the memory 1920. In this case, the memory 1920 may store the image data obtained from the peripheral device 1960 or store the video signal processed by the processor 1910. In an embodiment, the peripheral device 1960 may display the image through the display panel in real time.

The bus 1970 may provide a communication function between components of the computing system 1900. The bus 1970 may include at least one type of bus according to the communication protocol between the components.

In some embodiments, each component or combinations of two or more components described with reference to FIG. 1 to FIG. 19 may be implemented as a digital circuit, a programmable or non-programmable logic device or array, an application-particular integrated circuit (ASIC), or the like.

While some embodiments are described above, it is to be understood that the disclosure is not limited to the particularly described embodiments, but, on the contrary, is intended to cover various modifications and equivalent arrangements included within the scope of the appended claims.

## Claims

1. A random number generator, comprising:
an oscillator configured to generate a first oscillation signal;
a signal generator configured to generate a first clock signal based on the first oscillation signal and a pause signal, and to generate a second clock signal based on the pause signal;
a duty rectifier configured to generate a second oscillation signal based on the first clock signal, wherein a pulse width of the second oscillation signal is greater than a pulse width of the first clock signal; and
a sampler configured to sample the second oscillation signal based on the second clock signal.

2. The random number generator of claim 1, wherein the duty rectifier is further configured to count a number of rising edges of the first clock signal, and to generate the second oscillation signal based on the counted number.

3. The random number generator of claim 2, wherein the duty rectifier is further configured to:
output the second oscillation signal to have a high level based on the counted number being odd; and
output the second oscillation signal to have a low level based on the counted number being even.

4. The random number generator of claim 2 or 3, wherein the duty rectifier comprises a counter configured to count a least significant bit (LSB) based on the first clock signal.

5. The random number generator of any preceding claim, wherein the duty rectifier is further configured to maintain a level of the second oscillation signal based on a level of the first clock signal being maintained.

6. The random number generator of any preceding claim, further comprising a control logic circuit configured to generate an enable signal, and to periodically generate the pause signal based on the enable signal,
wherein the oscillator is further configured to generate the first oscillation signal based on receiving the enable signal.

7. The random number generator of claim 6, wherein the control logic circuit is further configured to generate the pause signal to have a low level based on a predetermined time elapsing from a rising edge of the enable signal.

8. The random number generator of claim 7, wherein the control logic circuit is further configured to generate an initialization signal,
wherein a frequency of the initialization signal is equal to a frequency of the pause signal, and
wherein the duty rectifier is initialized based on the initialization signal.

9. The random number generator of any preceding claim, wherein the signal generator comprises:
an AND gate configured to generate the first clock signal by performing a logical product operation on the first oscillation signal and the pause signal; and
an inverter configured to generate the second clock signal by inverting the pause signal.

10. The random number generator of claim 9, wherein the signal generator further comprises a delay circuit configured to delay at least one of the pause signal and the second clock signal.

11. The random number generator of claim 10, wherein the delay circuit comprises an even number of inverters.

12. The random number generator of any preceding claim, wherein the sampler is further configured to sample the second oscillation signal at a rising edge of the second clock signal.

13. The random number generator of any preceding claim, further comprising: a synchronizer configured to generate a synchronization signal based on the first oscillation signal and the pause signal,
wherein the signal generator is further configured to generate the first clock signal based on the first oscillation signal and the synchronization signal.

14. The random number generator of claim 13, wherein the synchronizer is further configured to generate the synchronization signal by sampling the pause signal at a falling edge of the first oscillation signal.

15. The random number generator of claim 13 or 14, wherein the signal generator comprises:
an AND gate configured to generate the first clock signal by performing a logical product operation on the first oscillation signal and the synchronization signal; and
an inverter configured to generate the second clock signal by inverting the synchronization signal.
